**Europäisches Patentamt**

**European Patent Office**

**Office européen des brevets**

(19)

(11) **EP 1 414 161 A1**

## (12) EUROPEAN PATENT APPLICATION
published in accordance with Art. 158(3) EPC

(43) Date of publication:
**28.04.2004 Bulletin 2004/18**

(21) Application number: **01953329.8**

(22) Date of filing: **27.07.2001**

(51) Int Cl.7: **H04B 1/16**

(86) International application number:
**PCT/JP2001/006505**

(87) International publication number:
**WO 2003/013012 (13.02.2003 Gazette 2003/07)**

(84) Designated Contracting States:
**AT BE CH CY DE DK ES FI FR GB GR IE IT LI LU MC NL PT SE TR**

(72) Inventor: **SADAHIRO, Keiichi,**
**Mitsubishi Denki KK**
**Chiyoda-ku, Tokyo 100-8310 (JP)**

(71) Applicant: **MITSUBISHI DENKI KABUSHIKI KAISHA**
**Tokyo 100-8310 (JP)**

(74) Representative: **Sajda, Wolf E., Dipl.-Phys. et al**
**MEISSNER, BOLTE & PARTNER**
**Postfach 86 06 24**
**81633 München (DE)**

## (54) RECEIVER

(57)     A receiver according to this invention comprises a mixing section (9) for frequency-converting a received high-frequency signal and outputting a base band signal, an amplifying section (10) for amplifying the base band signal; a load resistance (21, 22) provided between the mixing section (9) and the amplifying section (10), and a control section (3) for controlling an input signal level of the amplifying section (10) by changing a resistance value of the load resistance, thereby broadening a linear range of the receiver by simple structure and simple control.

# FIG.1

## Description

TECHNICAL FIELD

This invention relates to a receiver for use on a mobile communication radio transceiver, such as a cellular phone, having a limitation in reception-characteristic linear range.

BACKGROUND ART

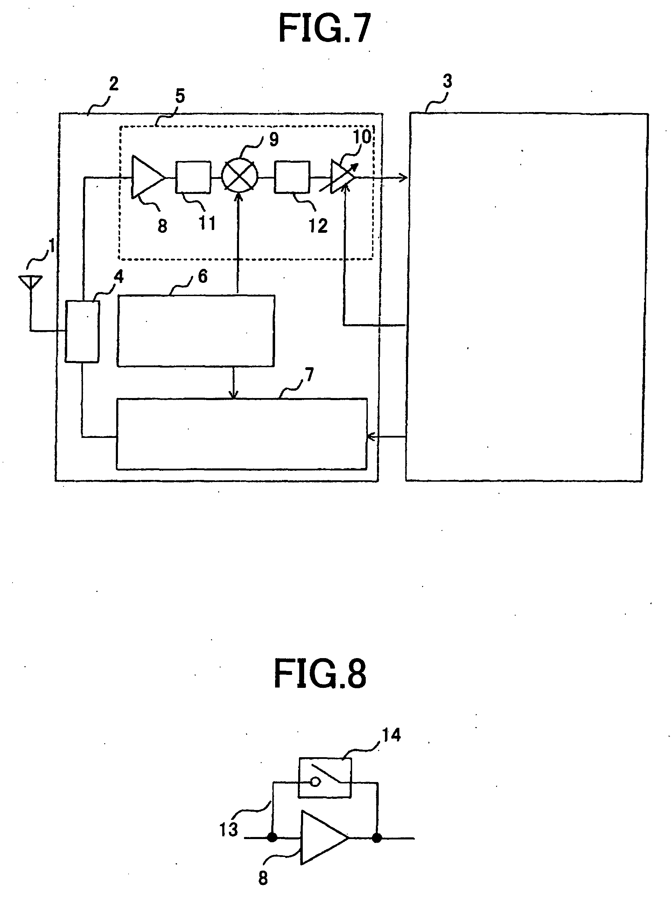

In a mobile communication radio transceiver such as a cellular phone for communication with the base station, there is a necessity to measure the strength of a radio wave received from the base station in order for proper control of communication and display to the user. For this reason, in the receiver used on such a mobile communication radio receiver, it is a conventional practice to carry out detection of a received signal strength indicator (RSSI) for grasping a reception input power level. Fig. 7 is a block diagram showing a cellular phone including the conventional receiver. In the figure, 1 is an antenna, 2 is a radio section for transmitting and receiving a radio signal through the antenna 1, and 3 is a control section for carrying out processing of a base band signal, control of radio communication using the antenna 1 and radio section 2, and gain-control of a hereinafter-referred variable-gain amplifier 10. The radio section 2 is configured with an antenna sharer 4, a receiving section 5 and transmitting section 7 connected to the antenna sharer 4, and a synthesizer section 6 for supplying a local oscillation signal to the receiving section 5 and transmitting section 7. Furthermore, the receiving section 5 is configured with a low-noise amplifier (LNA) 8 for amplifying a reception signal inputted from the antenna sharer 4, a high-frequency filter 11, a frequency mixer (MIX) 9 for mixing the reception signal with a local oscillation signal from the synthesizer section 6 and outputting a base band signal, a filter 12, and a variable-gain amplifier (AGC amplifier) 10.

Next, the operation will be explained. The radio signal received through the antenna 1 is passed through the antenna sharer 4 and inputted to the receiving section 5. In the receiving section 5, after the amplification in the LNA 8 and filtration in the high-frequency filter 11, the signal in the MIX 9 is mixed with a local oscillation signal from the synthesizer section 6 into a base band signal. Furthermore, it is filtered by the filter 12 and inputted to the AGC amplifier 10. The AGC amplifier 10 is gain-controlled by the control section 3 such that its output signal becomes a predetermined constant value. The control section 3 detects a received signal strength indicator of the received radio signal, from the gain control value.

Herein, in the case that the signal received has a great reception input power level, saturation takes place in the rear stage of the receiving section 5, or the AGC amplifier 10, deteriorating the linearity in the received signal strength indicator (RSSI) detection to be conducted in the control section 3. Consequently, when the reception input power level is great, the LNA 8, or the MIX 9 in the case of a passive device, is turned off in its power to lower the level of a signal to be input to the rear stage of the receiving section 5.

Otherwise, as shown in Fig. 8, a path 13 and switch 14 through the LNA 8 is provided. Usually, the switch is off. When the reception input power level is great, the switch 14 is turned on to lower the gain of LNA 8.

However, in the former case, because the LNA 8 and MIX 9 has a great individual difference in the gain when power being off and its frequency characteristic/ temperature characteristic and the LNA 8 is different in impedance at on/off power, individual-based correction is complicated and difficult. Meanwhile, in the latter case, the provision of the path 13 causes loss at an input portion of the LNA 8, worsening the NF of LNA 8. As a result, the receiving section 5 is worsened in reception sensitivity. Furthermore, there has been a problem that, when the switch 14 is turned over, the path is changed to cause phase discontinuity, deteriorating reception characteristic.

DISCLOSURE OF THE INVENTION

A receiver according to this invention comprises a mixing section for frequency-converting a received high-frequency signal and outputting a base band signal, an amplifying section for amplifying the base band signal, a load resistance provided between the mixing section and the amplifying section, and a control section for controlling a signal level of the base band signal to be input to the amplifying section by changing a resistance value of the load resistance, thereby making possible to broaden a linear range of the receiver by simple structure and simple control.

Also, A receiver according to this invention further comprises a high-frequency signal level detecting section for detecting a signal level of the received high-frequency signal, and the control section changing the resistance value of the load resistance to lower the signal level of the base band signal to be input to the amplifying section when the signal level of the high-frequency signal is equal to or higher than a predetermined threshold, thereby making possible to broaden a linear range of the receiver by simple structure and simple control.

Also, in a receiver according to this invention, the control section has a predetermined first threshold and a second threshold smaller than the first threshold, and changes the resistance value of the load resistance to lower the signal level of the base band signal to be input to the amplifying section when the signal level of the high-frequency signal is equal to or higher than the first threshold and changes the resistance value of the load resistance to raise the signal level of the base band signal to be input to the amplifying section when the signal level of the high-frequency signal is equal to or lower than the second threshold, thereby enabling stable control without excessive control.

Also, a receiver according to this invention further comprises a base band signal level detecting section for detecting the signal level of the base band signal to be input to the amplifying section, and the control section changes the resistance value of the load resistance to lower the input signal level when a detection level of the base band signal level detecting section is equal to or higher than a predetermined threshold, thereby enabling accurate control.

Also, in a receiver according to the invention, the control section has a predetermined first threshold and a second threshold smaller than the first threshold, and changes the resistance value of the load resistance to lower the signal level of the base band signal to be input to the amplifying section when the detection level of the base band signal level detecting section is equal to or higher than the first threshold and changes the resistance value of the load resistance to raise the signal level of the base band signal to be input to the amplifying section when the input signal level is equal to or lower than the second threshold, enabling accurate and stable control.

Also, a receiver according to this invention comprises a mixing section for frequency-converting a received high-frequency signal and outputting a base band signal, a variable-gain amplifying section for amplifying the base band signal, a gain control section for controlling a gain of the variable-gain amplifying section such that an output thereof becomes constant, and a control section for controlling to lower a signal level of the base band signal to be input to the variable-gain amplifying section when a gain value of the variable-gain amplifying section under control of the gain control section is equal to or smaller than a predetermined threshold; thereby making possible to broaden a linear range of the receiver by simple structure and further simple control and enabling accurate control.

Furthermore, in a receiver according to this invention, the control section has a predetermined first threshold and a second threshold smaller than the first threshold, and controls to raise the signal level of the base band signal to be input to the variable-gain amplifying section when the gain of the variable-gain amplifying section is equal to or higher than the first threshold and controls to lower the signal level of the base band signal when the gain of the variable-gain amplifying section is equal to or smaller than the second threshold, hereby enabling accurate and stable control.

## BRIEF DESCRIPTION OF THE DRAWINGS

Fig. 1 is a functional block diagram of a cellular phone of Embodiment 1 of this invention.

Fig. 2 is a diagram showing a relationship between a reception input power level and an AGC amplifier input level of a cellular phone of Embodiment 1 of this invention.

Fig. 3 is a diagram showing a relationship between a reception input power level and an AGC amplifier input level of a portable radio transceiver of Embodiment 1 of this invention.

Fig. 4 is a diagram showing a configuration of a receiving section the portable radio transceiver of Embodiment 1 of this invention.

Fig. 5 is a diagram showing a relationship between a reception input power level and an AGC amplifier input level of a portable radio transceiver of Embodiment 2 of this invention.

Fig. 6 is a diagram showing a relationship between a reception input power level and an AGC amplifier set gain of a portable radio transceiver of Embodiment 3 of this invention.

Fig. 7 is a block diagram of a conventional cellular phone.

Fig. 8 is a diagram showing a configuration example of a receiving section of the conventional cellular phone.

## BEST MODE FOR CARRYING OUT THE INVENTION

Hereunder, in order to explain this invention in greater detail, the best mode for carrying the invention will be explained according to the accompanying drawings.

## Embodiment 1

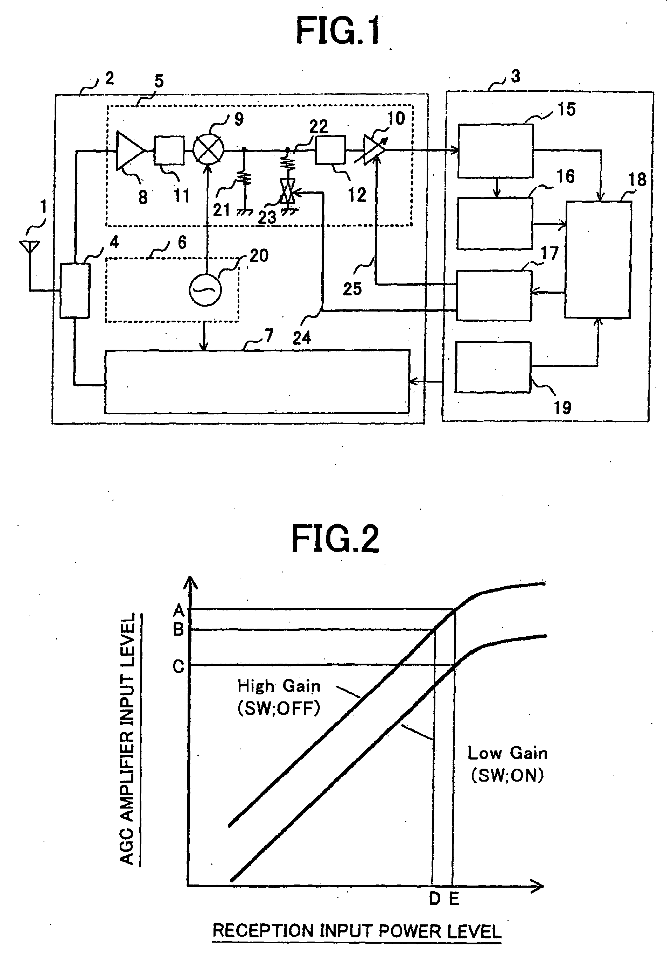

Hereunder, Embodiment 1 of the invention will be explained on the basis of the drawings. Fig. 1 is a functional block diagram of a radio apparatus in direct conversion scheme including a receiver according to the invention, e.g. of a cellular phone for mobile communications. Herein, the direct.conversion scheme is a receiving scheme of direct conversion of from a reception signal into a base band signal without the intervention of an intermediate frequency.

In the figure, 1 is an antenna, 2 is a radio section for transmitting and receiving a radio signal through the antenna 1, and 3 is a control section for processing a base band signal and controlling the radio section 2.

The radio section 2 is configured with an antenna sharer 4, a receiving section 5 and transmitting section 7 connected to the antenna sharer 4, and a synthesizer section 6. The synthesizer section 6 includes a local oscillator 20, to supply a local oscillation signal to the receiving section 5 and the transmitting section 7. Furthermore, the receiving section 5 is configured with a low-noise amplifier (LNA) 8 to amplify a receiving signal inputted from the antenna sharer 4, a high-frequency filter 11, a frequency mixer (MIX) 9, a filter 12, and a variable-gain amplifier (AGC amplifier) 10. The MIX 9 carries out frequency conversion by mixing the reception signal with a local oscillation signal from the local oscillator 20, and outputs a base band signal. Its output section is connected with a load resistance 21 having a resistance value $R_{L1}$, a load resistance 22 connected in parallel therewith and having a resistance value $R_{L2}$ and a switch 23 connected in series with the load resistance 22. The switch 23 is switched on/off by a control signal 24 from the control section 3.

Meanwhile, the control section 3 is configured with an A/D converter 15 to A/D-convert an output from the AGC amplifier 10, a reception data processing section 16, a control signal processing section 17, an operating section 18 and a memory 19. The control signal processing section 17 outputs a control signal 25 for controlling a gain of the AGC amplifier 10 such that an output thereof becomes a constant value, and a control signal noted above.

Now, the operation will be explained. A radio wave transmitted from a base station is received through the antenna 1. The received high-frequency signal is passed through the antenna sharer 4 and inputted to the receiving section 5. In the receiving section 5, it is amplified by the LNA 8 and filtered by the high-frequency filter 11, thereafter being inputted to the MIX 9. In the MIX 9, it is mixed with a local oscillation signal from the local oscillator 20, being directly frequency-converted into a base band signal and amplified.

The base band signal outputted from the MIX 9 is filtered in the filter 12 and amplified in the AGC amplifier 10. Then, it is inputted to the A/D converter 15 of the control section 3 and converted into a digtal signal, being signal-processed in the reception data processing section 16. Herein, set gain of the AGC amplifier 10 is feedback-controlled by the control signal 25 from the control section 3 such that an output signal thereof becomes a predetermined constant value. In the control section 3, a received signal strength indicator (RSSI) of the received radio signal is detected on the basis of the set gain value and the frequency correction data and temperature correction data stored in the memory 19.

In the meanwhile, the mixing amplifier section configured by the MIX 9 and the load resistance connected to an output section thereof has a gain varying depending upon a magnitude of the load resistance. Generally, because the MIX 9 has a high output impedance, the gain increases in the case the load resistance is great and matched with the output impedance of MIX 9. In case the load resistance is smaller, loss occurs to decrease the gain. As mentioned before, the output section of MIX 9 is connected with the load resistance 21, the load resistance 22 connected in parallel with this and the switch 23. In the case the switch 23 is off, the MIX 9 has a load resistance value $R_{L1}$. In the case of the switch 23 is on, the MIX 9 has a load resistance value $(R_{L1} \times R_{L2}) / (R_{L1} + R_{L2})$. In case the load resistance value $R_{L1}$ is selected so as to match with the output impedance of MIX 9, there is a relationship $R_{L1} > (R_{L1} \times R_{L2}) / (R_{L1} + R_{L2})$ so that the mixing amplifier section has a gain decreased in the case the switch 23 is on as compared with the case of off thereof. Assuming the resistance value $R_{L1}$ of the load resistance 21 is fixed, the variation width of gain due to on/off of the switch 23 is determined by a magnitude of the resistance value $R_{L2}$ of load resistance 22. Consequently, a required gain variation width can be obtained by setting a proper resistance value $R_{L2}$.

Fig. 2 shows a relationship between a reception input power level as a signal level of received high-frequency signal and the input signal level of AGC amplifier 10 corresponding thereto, when the switch 23 is off and on. As mentioned before, the gain of mixing amplifier section lowers in the case the switch 23 is on as compared with the case of off thereof. Due to this, the input level to AGC amplifier 10 is lower in the case the switch 23 is on than the case of off thereof.

Herein, for the convenience of explanation, the section of from the antenna 1 to the antenna sharer 4, LNA 8, high-frequency filter 11, MIX 9, filter 12 and AGC amplifier 10 input section is referred to as an antenna 1 - AGC amplifier 10 input section. In the figure, the reception input power level E represents a range in which the antenna 1 input - AGC amplifier 10 input section is in linear operation. At this time, the AGC amplifier 10 has an input level A when the switch 23 is off and C when the switch 23 is on. Meanwhile, the AGC amplifier input level B represents an upper limit of input level that the AGC amplifier 10 is in linear operation. This shows that, in the case the switch 23 is off, the AGC amplifier 10 goes into saturation at a reception input power level equal to or higher than D, i.e. at a level lower than a level E in the antenna 1 input - AGC amplifier input section. Consequently, in the case the switch 23 is off, the level D is the upper limit value of linear operation of the entire receiving section 5.

For this reason, the control in the below is carried out. Namely, thresholds $Pin_{TH1}$ and $Pin_{TH2}$ ($D \geq Pin_{TH1} > Pin_{TH2}$) are provided for the reception input power level. In the initial state, when the reception input power level is lower than the threshold $Pin_{TH1}$, the switch 23 is positioned off while, when higher than the threshold $Pin_{TH1}$, the switch 23 is positioned on. Thereafter, control is made such that, when the reception input power level is equal to or higher than the threshold $Pin_{TH1}$, the switch 23 is turned on while, when equal to or lower than the threshold $Pin_{TH2}$, the switch 23 is turned off.

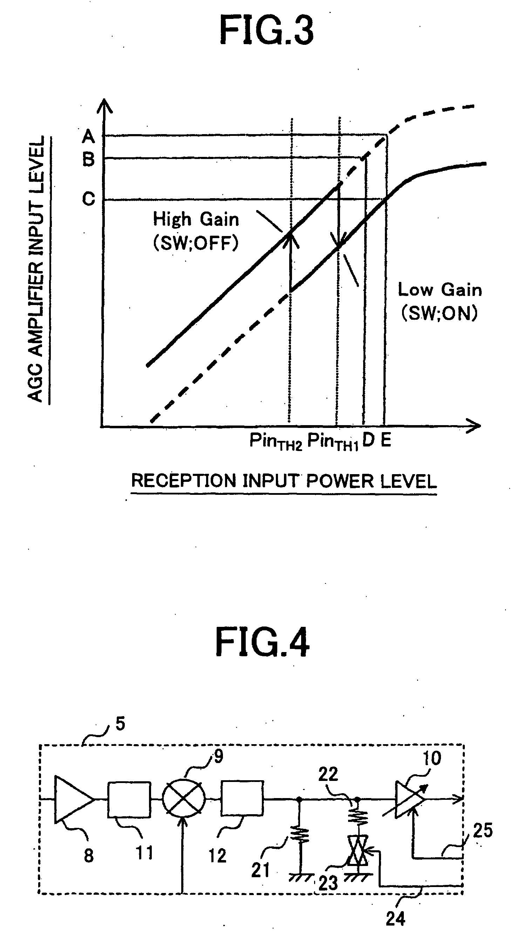

Fig. 3 shows a relationship between a reception input power level and the input signal level to AGC amplifier 10 corresponding thereto, in the case of carrying out the above control. The same references as Fig. 2 denote the identical or corresponding elements and hence explanation is omitted. In the figure, when reception input power level is equal to or higher than the threshold $Pin_{TH1}$, the switch 23 is turned on to lower the gain of mixing amplifier section, thereby controlling to lower the input signal level to AGC amplifier 10. Due to this, even in the case the reception input power level is E, the AGC amplifier 10 has an input signal level of C (< B) at which the AGC amplifier 10 does not go into saturation. Thus, the receiving section 5 has a linear operation range of up to the reception input power level of E. On the other hand, when reception input power level is equal to or lower than the threshold $Pin_{TH2}$, the switch 23 is tuned off to lower the gain of mixing amplifier section thereby controlling to raise the input signal level to AGC amplifier 10. Due to this, reception sensitivity is prevented from deteriorating at weak reception signal. Meanwhile, the switch control is made by the gain control of mixing amplifier circuit, i.e. the level control of a base band signal after frequency conversion to be inputted to the AGC amplifier 10, resulting in a state simply applying offset by an amount of gain. Thus, there is almost no affection upon the correction value of frequency characteristic and temperature characteristic to the high-frequency signal. Furthermore, because the thresholds $Pin_{TH1}$ and $Pin_{TH2}$ are provided to have a hysteresis characteristic, excessive gain switching will not occur.

Herein, description is made on a detection of a received signal strength indicator (RSSI) of a received radio signal, i.e. a method to detect a reception input power level. A reception input level Pin can be computed on the basis of a set gain $G_1$ on AGC amplifier 10, an input level $P_{ref}$ to A/D converter 15, a reference gain $G_2$ of the antenna 1 input - AGC amplifier 10 input section, a frequency deviation (correction value) $G_{0\_freq}$ of the antenna 1 input - AGC amplifier 10 input section, a temperature deviation (correction value) $G_{0\_temp}$ of the antenna 1 input - AGC amplifier 10 input section, and a gain difference $G_{0\_offset}$ of the antenna 1 input - AGC amplifier 10 input section at between high gain (when switch 23 is off) and low gain (when switch 23 is on). This computation is made, for example, in the operating section 18 of control section 3.

The set gain $G_1$ on AGC amplifier 10 is variable, which is set such that the input level $P_{ref}$ to A/D converter 15 becomes a predetermined constant value (constant). Also, the frequency deviation $G_{0\_freq}$ is a difference between a gain of the antenna 1 input - AGC amplifier 10 input section at a certain reception frequency and a reference gain $G_0$. With consideration to device individual difference, measurement is previously made at a plurality of points of frequencies within a reception frequency band on each radio transceiver, to store as a correction value to the memory 18. Meanwhile, the temperature deviation $G_{0\_temp}$ is a difference between a gain of the antenna 1 input - AGC amplifier 10 input section at a certain temperature and a reference gain $G_0$. This is previously determined from the measurement on several sample transceivers, and stored as a correction value common to the radio transceivers to the memory 18. Furthermore, the gain difference $G_{0\_offset}$ is a gain difference between upon off of the switch 23 (at high gain) and upon on of the switch 23 (at low gain) in the MIX 9. With consideration to the individual difference of receiving section 5, measurement is previously made on each radio transceiver, to store as a correction value to the memory 18.

Using the above values, a reception input power level Pin is computed by the following computation equation.

At high gain:

$$Pin = G_0 + G_{0\_freq} + G_{0\_temp} + G_1 + P_{ref}$$

At low gain:

$$Pin = G_0 - G_{0\_offset} + G_{0\_freq} + G_{0\_temp} + G_1 + P_{ref}$$

Namely, the reception input power level at low gain can be determined merely by subtracting the gain difference $G_{0\_offset}$ from a level at high gain. There is no need to vary the frequency deviation $G_{0\_offset}$/temperature deviation $G_{0\_temp}$ correspondingly to gain switching. The computation with the above computation equation is made several times to take an averaged result as a reception input power level. In the case that this value exceeds upward or downward the threshold , the gain of mixing amplifier section is switch-controlled by turning on/off the switch 23. When switching the gain, the set gain $G_1$ on AGC amplifier 10 is set again by taking the amount of gain difference $G_{0\_offset}$ into consideration. Due to this, convergence on the AGC amplifier 10 upon gain switching is made faster.

In this manner, the radio apparatus in Embodiment 1 of the invention, when the reception input power level is high, sets low the gain of mixing amplifier section by decreasing the load resistance of MIX 9 and effects control to lower the input signal level to AGC amplifier 10, thus broadening the linear operation range of receiving section 5. On the other hand, when the reception input power level is low, the gain of mixing amplifier section is set high by increasing the load resistance of MIX 9 and the input signal level to AGC amplifier 10 is controlled to be raised, not to lower unnecessarily, thus not having a bad effect, such as sensitivity deterioration, upon reception characteristic. Also, because control is made on the base band signal to be inputted to the AGC amplifier 10 after frequency conversion, there is almost no change in frequency characteristic or temperature characteristic, hence eliminating the necessity of storing a correction value corresponding to control. Meanwhile, because two different values are set to the thresholds of reception input power level to provide control with hysteresis characteristic, stable control is made possible without causing excessive gain switching. Furthermore, because a gain of the AGC amplifier 10 is set by taking into consideration the gain switching differential of mixing amplifier section when controlling the input signal level to AGC amplifier 10, convergence on the AGC amplifier 10 is made fast, making possible stable control.

Incidentally, as shown in Fig. 4, in the receiving section 5 of Fig. 1, a filter 12 may be provided between the MIX 9 and the load resistance 21. The filter 12 is designed to convert an output impedance of the mixing amplifier section configured by the MIX 9 and load resistance and to match with an input impedance of the AGC amplifier 10. By the above-mentioned arrangement, there is a case that designing the filter 12 becomes easy. In this case, the filter 12 is designed to match the output impedance of MIX 9 with the input impedance of AGC amplifier 10 including the load resistance. Also when providing the filter 12 between the load resistance 21 and the load resistance 22, there is a case that the filter is facilitated in design. In any of the cases, obtainable effects other than this are the same as those of Fig. 1 structure.

Embodiment 2

Now Embodiment 2 of this invention will be explained. Embodiment 2 is a cellular phone having a functional block shown in Fig. 1. Although switch-control of the gain of mixing amplifier section is carried out on the basis of a reception input power level in Embodiment 1, control is carried out on the basis of detected signal level of a base band signal to be inputted to the AGC amplifier 10 in this Embodiment 2. The other operation is similar to Embodiment 1 and explanation is omitted.

First, described is a method to detect an input level of a base band signal to be inputted to the AGC amplifier. The input signal level $Pin_{AGC}$ to APC amplifier can be computed on the basis of a set gain on AGC amplifier 10 and an input level $P_{ref}$ to A/D converter 15. This computation is carried out, for example, in the operating section 18 of the control section 3. The computation equation on the input signal level $Pin_{AGC}$ to AGC amplifier is expressed as follows:

$$Pin_{AGC} = G_1 + P_{ref}$$

The computation with this computation equation is made several times to take an averaged result as an AGC amplifier input signal level. On the basis of a relationship between this value and a hereinafter-referred threshold, switch-control is carried out on the gain of mixing amplifier section by turning on/off the switch 23.

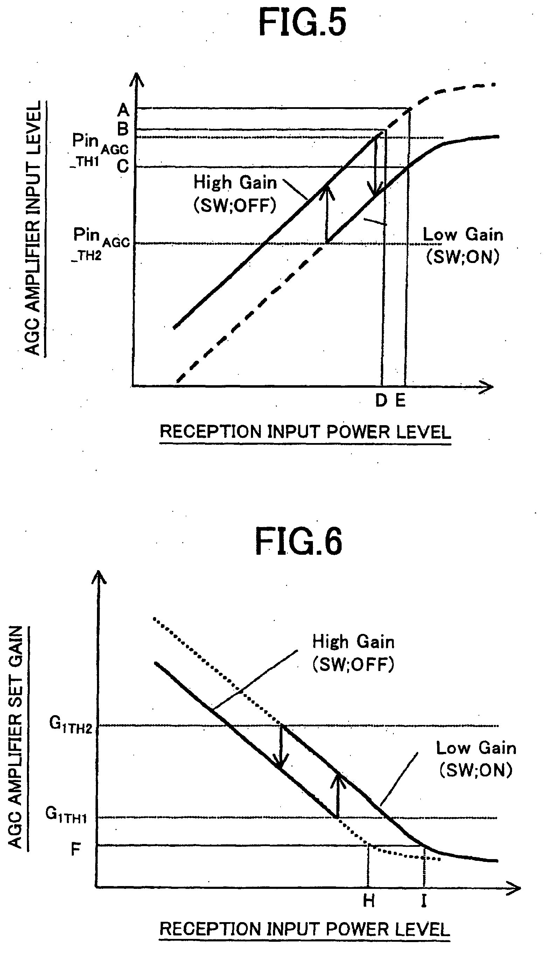

Fig. 5 shows a relationship between a reception input power level and the input signal level to AGC amplifier 10 corresponding thereto in the case of carrying out control of the above. The same references as in Fig. 1 denote the identical or corresponding elements and explanation is omitted. In the figure, $Pin_{AGC\_TH1}$ and

$Pin_{AGC\_TH2}$ are thresholds for input signal level to AGC amplifier 10. The two thresholds have a relationship to be expressed in the following, by the use of an AGC amplifier input level B as the upper limit of linear operation of the AGC amplifier 10 and a gain difference $G_{0\_offset}$ of the antenna 1 input - AGC amplifier 10 input section at between high gain (when the switch 23 is off) and low gain (when the switch 23 is on).

$$B \geq Pin_{AGC\_TH1} > Pin_{AGC\_TH1} - G_{0\_offset} > Pin_{AGC\_TH2}$$

Next, control operation will be explained. When the input signal level to AGC amplifier 10 is equal to or higher than the threshold $Pin_{AGC\_TH1}$, the switch 23 is turned on to lower the gain of mixing amplifier section thereby effecting control to lower the input signal level to AGC amplifier 10. Due to this, even in the case the reception input power level is E, the AGC amplifier 10 has an input signal level of C (< B) so that the AGC amplifier 10 does not go into saturation. Consequently, the linear operation range of receiver section 5 is up to the reception input power level E. On the other hand, when the input signal level to AGC amplifier 10 is equal to lower than the threshold $Pin_{AGC\_TH2}$, the switch 23 is turned off to raise the gain of mixing amplifier section thereby effecting control to raise the input signal level to AGC amplifier 10. Due to this, reception sensitivity is prevented from deteriorating at weak reception signal.

In this manner, the cellular phone in Embodiment 2 of the invention, when the input level to AGC amplifier 10 is high, sets low the gain of mixer amplifier section and effects control to lower the input signal level to AGC amplifier 10, thus making possible to broaden the linear operation range of receiving section 5. On the other hand, when the input signal level to AGC amplifier 10 is low, the gain of mixing amplifier section is set high to effect control such that the input signal level to AGC amplifier 10 is raised not to lower unnecessarily, thus not having a bad effect, such as sensitivity deterioration, upon reception characteristic. Also, because of control is carried out on the basis of the input signal level to AGC amplifier 10, accurate control is possible such that the input signal level to AGC amplifier 10 is within the linear operation range of AGC amplifier 10, regardless of the effect of the variation in frequency/temperature in the antenna 1 input - AGC amplifier 10 input section. Furthermore, because two different values are set to the thresholds of input signal level to AGC amplifier 10 to provide control with hysteresis characteristic, stable control is possible without causing excessive gain switching.

Embodiment 3

Now Embodiment 3 of this invention will be explained. Embodiment 3 is a cellular phone having a functional block shown in Fig. 1. Although switch-control on the gain of mixing amplifier section is carried out on the basis of a reception input power level Embodiment 1, control is carried out in this Embodiment 3 on the basis of a set gain on AGC amplifier 10 as a variable-gain amplifier section. The other operation is the same as that in Embodiment 1 and hence explanation is omitted.

Fig. 6 shows a relationship between a reception input power level and the set gain on AGC amplifier 10 corresponding thereto. In the figure, the set gain F on AGC amplifier 10 represents the lower limit of the set gain allowing the AGC amplifier 10 to operate linearly. This shows that, in the case the switch 23 is off, the AGC amplifier 10 goes into saturation at a reception input power level equal to or higher than H while, in the case the switch 23 is on, the AGC amplifier 10 goes into saturation at a reception input power level equal to or higher than I. Namely, even where the antenna 1 input - AGC amplifier 10 input section have an upper limit I of linear operation, in the case the switch 23 is off, the reception input power level H is an upper limit value of linear operation for the entire receiving section 5.

$G_{1TH1}$ and $G_{1TH2}$ are thresholds for the set gain on AGC amplifier 10. The two thresholds has a relationship to be expressed as in the following, by the use of an AGC amplifier input level B as an upper limit of linear operation of AGC amplifier 10 and a gain difference $G_{0\_offset}$ of the antenna 1 input - AGC amplifier 10 input section 10 at between high gain (when switch 23 is off) and low gain (when switch 23 is on).

$$F \leq G_{1TH1} < G_{1TH1} + G_{0\_offset} < G_{1TH2}$$

Next, control operation will be explained. When the set gain on AGC amplifier 10 is equal to or lower than the threshold $G_{1TH1}$, the switch 23 is turned on to lower the input signal level to AGC amplifier 10 by lowering the gain of mixing amplifier section, thereby effecting to raise the set gain on AGC amplifier 10. Due to this, even where the reception input power level is I, the set gain on AGC amplifier 10 becomes F ($\leq$ F) and the AGC amplifier 10 will not go into saturation. Consequently, the linear operation range of receiving section 5 is up to the reception input power level I that is an upper limit of linear operation of the antenna 1 input - AGC amplifier 10 input section. On the other hand, when the set gain on AGC amplifier 10 is equal to or higher than the threshold $G_{1TH2}$, the switch 23 is turned off to the input signal level to AGC amplifier 10 by raising the gain of mixing amplifier section thereby raising and effecting control to lower the set gain on AGC amplifier 10. Due to this, reception sensitivity at weak reception signal is prevented from deteriorating.

In this manner, the cellular phone in Embodiment 3 of the invention, when the set gain on AGC amplifier 10 is low, sets low the gain of mixer amplifier section and effects control to lower the input signal level to AGC amplifier 10, thus raising the set gain on AGC amplifier 10, resulting in that the linear operation range of receiving section 5 can be broadened. On the other hand, when the set gain on AGC amplifier 10 is high, the gain of mixing amplifier section is set high and effects control to raise the input signal level to AGC amplifier 10, not to lower unnecessarily, thus not having a bad effect, such as sensitivity deterioration, upon reception characteristic. Also, because of control on the basis of the set gain on AGC amplifier 10, accurate control is possible such that the input signal level to AGC amplifier 10 is within the linear operation range of AGC amplifier 10, irrespective of the variation in frequency or temperature in the antenna 1 input - AGC amplifier 10 input section. Furthermore, because two different values are set for the threshold of set gain on AGC amplifier 10 to provide control with hysteresis characteristic, stable control is possible without causing excessive gain switching. Furthermore, control is effected without computing a reception input power level or an input signal level to AGC amplifier 10, simple control is possible.

## Claims

1. A receiver comprising:

   a mixing section (9) for frequency-converting a received high-frequency signal and outputting a base band signal;
   an amplifying section (10) for inputting and amplifying the base band signal;
   a load resistance (21, 22) provided between the mixing section (9) and the amplifying section (10); and
   a control section (3) for controlling a signal level of the base band signal to be input to the amplifying section (10) by changing a resistance value of the load resistance.

2. A receiver according to claim 1, further comprising a high-frequency signal level detecting section (3) for detecting a signal level of the received high-frequency signal,
   wherein the control section (3) changes the resistance value of the load resistance to lower the signal level of the base band signal to be input to the amplifying section (10) when the signal level of the high-frequency signal is equal to or higher than a predetermined threshold.

3. A receiver according to claim 2, wherein the control section (3) has a predetermined first threshold and a second threshold smaller than the first threshold, and changes the resistance value of the load resistance to lower the signal level of the base band signal to be input to the amplifying section (10) when the signal level of the high-frequency signal is equal to or higher than the first threshold and changes the resistance value of the load resistance to raise the signal level of the base band signal to be input to the amplifying section (10) when the signal level of the high-frequency signal is equal to or lower than the second threshold.

4. A receiver according to claim 1, further comprising a base band signal level detecting section (3) for detecting the signal level of the base band signal to be input to the amplifying section (10),

wherein the control section (3) changes the resistance value of the load resistance to lower the signal level of the base band signal to be input to the amplifying section (10) when a detection level of the base band signal level detecting section (3) is equal to or higher than a predetermined threshold.

5. A receiver according to claim 4, wherein the control section (3) has a predetermined first threshold and a second threshold smaller than the first threshold, and changes the resistance value of the load resistance to lower the signal level of the base band signal to be input to the amplifying section (10) when the detection level of the base band signal level detecting section is equal to or higher than the first threshold and changes the resistance value of the load resistance to raise the signal level of the base band signal to be input to the amplifying section (10) when the detection level is equal to or lower than the second threshold.

6. A receiver comprising:

a mixing section (9) for frequency-converting a received high-frequency signal and outputting a base band signal;
a variable-gain amplifying section (10) for inputting and amplifying the base band signal;
a gain control section (3) for controlling a gain of the variable-gain amplifying section (10) such that an output thereof becomes constant; and
a control section (3) for controlling to lower a signal level of the base band signal to be input to the variable-gain amplifying section (10) when a gain value of the variable-gain amplifying section (10) under control of the gain control section (3) is equal to or smaller than a predetermined threshold.

7. A receiver according to claim 6, wherein the control section (3) has a predetermined first threshold and a second threshold smaller than the first threshold, and controls to raise the signal level of the base band signal to be input to the variable-gain amplifying section (10) when the gain of the variable-gain amplifying section (10) is equal to or higher than the first threshold and controls to lower the signal level of the base band signal when the gain of the variable-gain amplifying section (10) is equal to or smaller than the second threshold.

# FIG.1

# FIG.2

AGC AMPLIFIER INPUT LEVEL

A
B
C

High Gain
(SW;OFF)

Low Gain
(SW;ON)

D E

RECEPTION INPUT POWER LEVEL

# FIG.3

# FIG.4

# FIG.5

RECEPTION INPUT POWER LEVEL

# FIG.6

RECEPTION INPUT POWER LEVEL

# FIG.7

# FIG.8

## INTERNATIONAL SEARCH REPORT

| International application No. |
|---|
| PCT/JP01/06505 |

**A. CLASSIFICATION OF SUBJECT MATTER**
Int.Cl⁷ H04B1/16

According to International Patent Classification (IPC) or to both national classification and IPC

**B. FIELDS SEARCHED**

Minimum documentation searched (classification system followed by classification symbols)
Int.Cl⁷ H04B1/16

Documentation searched other than minimum documentation to the extent that such documents are included in the fields searched
Jitsuyo Shinan Koho 1922-1996 Toroku Jitsuyo Shinan Koho 1994-2001
Kokai Jitsuyo Shinan Koho 1971-2001 Jitsuyo Shinan Toroku Koho 1996-2001

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 10-233711 A (Mitsubishi Electric Corporation), 02 September, 1998 (02.09.98) (Family: none) | 1-7 |
| A | JP 10-084294 A (Casio Computer Co., Ltd.), 31 March, 1998 (31.03.98) (Family: none) | 1-7 |
| A | JP 57-152854 U (Fujitsu Ten Limited), 25 September, 1982 (25.09.82) (Family: none) | 1-7 |
| A | JP 59-016407 A (NEC Corporation), 27 January, 1984 (27.01.84) (Family: none) | 1-7 |
| A | JP 57-204722 U (Tokyo Shibaura Denki K.K.), 27 December, 1982 (27.12.82) (Family: none) | 1-7 |

☐ Further documents are listed in the continuation of Box C.  ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 23 October, 2001 (23.10.01) | 06 November, 2001 (06.11.01) |

| Name and mailing address of the ISA/ | Authorized officer |
|---|---|
| Japanese Patent Office | |
| Facsimile No. | Telephone No. |

Form PCT/ISA/210 (second sheet) (July 1992)

13